# EUROPEAN PATENT APPLICATION

(11) **EP 1 030 361 A1**
(43) Date of publication of application: **23.08.2000**
(21) Application number: 00103000.6
(22) Date of filing: 14.02.2000
(51) Int. Cl.: H01L 21/768

(54) **Manufacturing method of semiconductor device using a dual damascene process**

(30) Priority: 15.02.1999 JP 3630599
(71) Applicant: NEC CORPORATION, Tokyo (JP)
(72) Inventor: Ikeda, Masayoshi, Minato-ku, Tokyo (JP)
(74) Representative: Glawe, Delfs, Moll & Partner

(57) **Abstract**

A method of manufacturing a semiconductor device, according to the present invention, has the following process. First, a dummy plug (102, 302) and an interlayer insulating film (5, 15), with the interlayer insulating film (5, 15) being made of a material which is different from that of the dummy plug (102, 302), so as to cover, at least, the side wall of the dummy plug (102, 302) on a conductive film (1). Then, a mask layer (6) is formed on top of the interlayer insulating film (5, 15), where the mask layer has an aperture (103) with its width being longer than that of the dummy plug (102, 302). And an interconnective ditch (104) is formed in the insulation film (5, 15) so as to expose the top surface of the dummy plug (102, 302) on the bottom of the interconnective ditch (104), by etching off part of the interlayer insulating film (5, 15) using the mask layer as an etching mask. At this time, the top surface of the dummy plug (102, 302) is located at either an identical level to or a lower level than the bottom of the interconnective ditch (104).

## Description

### BACKGROUND OF THE INVENTION

### Field of the Invention

The present invention relates to a manufacturing method of a semiconductor device. It is particularly related to the method of manufacturing a semiconductor device that has a multi-layered interconnect structure, which can improve electromigration endurance, control the increase in the via resistance, and prevent an interconnect fracture from occurring.

### Description of the Related Art

As the improvement of integration, microstructure, and performance of the semiconductor device progresses, rather than using the conventional via plug and interconnective materials of Aluminum (Al) and Tungsten (W), materials with a smaller resistance are preferred. One of the typically used materials is copper (Cu), which is also noted for being able to enhance the electromigration endurance of interconnects.

However, the formation of copper interconnects by the etching process has been impossible, since copper is difficult to etch. To solve this problem, a damascene process has been devised to fill holes or ditches formed in advance with an interconnective material such as copper and remove the excessive part of the interconnective material by chemical mechanical polishing (CMP), so as to form a via plug and an interconnect.

It has become possible to form interconnects without directly etching difficult-to-etch materials, such as copper, by using this damascene process.

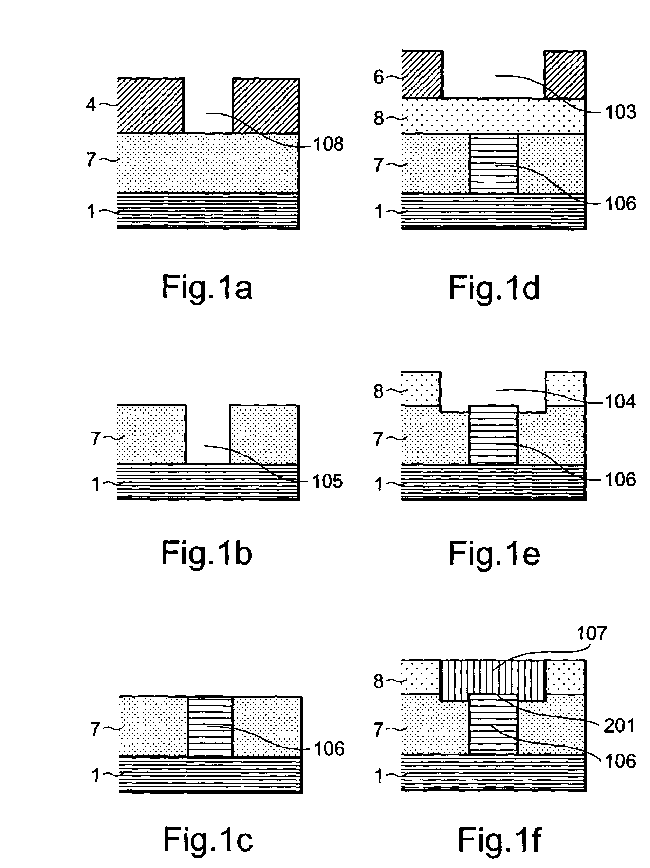

The single damascene process is one of the basic damascene processes. The single damascene process that fabricates a semiconductor device will be explained below with reference to Fig. 1.

First, an initial interlayer film 7 is formed on a conductor 1 (See Fig. 1a) . Afterwards, the surface of the initial interlayer film 7 is coated with an initial photosensitive organic film 4, which is then subjected to an exposure and development process; thus forming a hole 108 on the initial photosensitive organic film 4.

Next, as shown in Fig. 1b, a via hole 105 reaching down to the conductor 1 is formed on the initial interlayer film 7 by an etching process using the initial photosensitive organic film 4 as a mask. The photosensitive organic film 4 is then removed.

Subsequently, the via hole 105, formed on the interlayer film 7, is filled with an interconnective material. The excessive part of the interconnective material is then polished, using CMP; thus forming a via plug 106, as shown in Fig. 1c. Next, as shown in Fig. 1d, a second interlayer film 8 is formed on top of the initial interlayer film 7 and via plug 106. The surface of the second interlayer film 8 is coated with a second photosensitive organic film 6; which is then subjected to an exposure and development process, so as to form a ditch 103 on the second photosensitive organic film 6.

Afterwards, as shown in Fig. 1e, an interconnective ditch 104 reaching the surface of the via plug 106 is formed by an etching process, using the second photosensitive organic film 6 as a mask; which is then removed.

Lastly, the interconnective ditch 104 is filled with an interconnective material, and an interconnect 107 is then formed using CMP, as shown in Fig. 1f. In this case, it is possible to use a difficult-to-etch material for the via plug and interconnect. However, since the via plug 106 and interconnect 107 are formed separately, an interface 201 is formed between them. This may cause a problem resulting in an increase in the resistance between the via plug and the interconnect, and a decrease in the electromigration endurance.

In order to solve this problem, the dual damascene process has been devised to simultaneously form the via plug and interconnect.

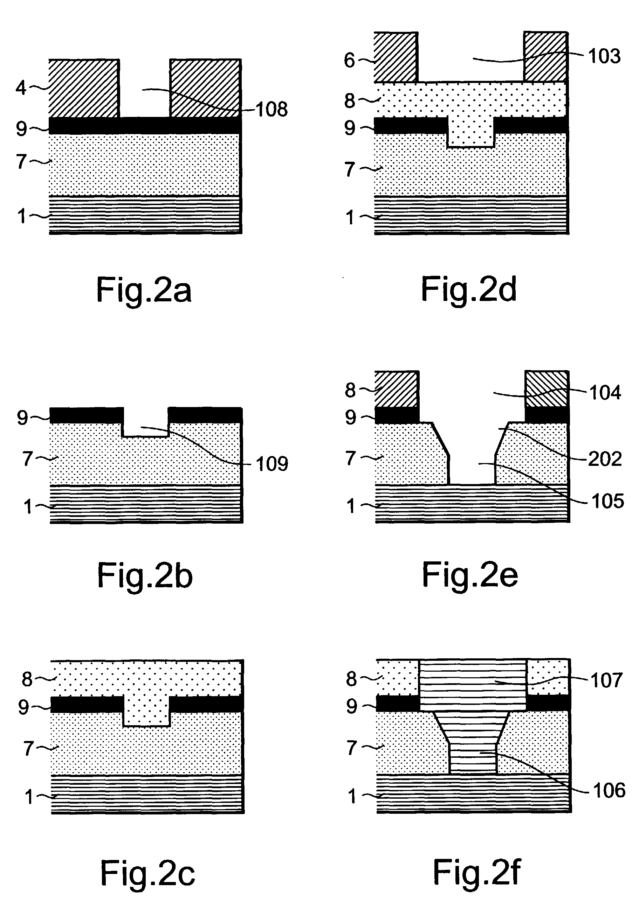

The conventional dual damascene process of fabricating a semiconductor device will be explained below with reference to Figs. 2a to 2f. First, as shown in Fig. 2a, an initial interlayer film 7 (e.g., a SiO₂ film) is formed on top of a conductor 1. A ditch-etching-stopper film 9 (e.g., a Si₃N₄ film) is then formed on the resultant surface. The above formed ditch-etching-stopper film 9 is then coated with an initial photosensitive organic film 4, which is then subjected to an exposure and development process; thus forming a hole 108 on the initial photosensitive organic film 4.

Next, as shown in Fig. 2b, a hole 109 is formed by selectively etching the stopper film 9 and also the initial interlayer film 7 to a certain depth using the photosensitive organic film 4 as a mask. The photosensitive organic film 4 is then removed. Afterwards, as shown in Fig. 2c, a second interlayer film 8 (e.g., a SiO₂ film) is formed on top of the stopper film 9 and in the hole 109.

Thereafter, as shown in Fig. 2d, the second interlayer film 8 is coated with a second photosensitive organic film 6, which is then subjected to an exposure and a development process; thus forming a ditch 103 on the second photosensitive organic film 6. Subsequently, as shown in Fig. 2e, an interconnective ditch 104 is formed by an etching process using the second photosensitive organic film 6 as a mask. A via hole 105 is then formed by an etching process, using the ditch-etching-stopper film 9 as a mask.

Lastly, as shown in Fig. 2f, the via hole 105 and interconnective ditch 104 are filled with an interconnective material; which is then subjected to the CMP process, so as to form a via plug 106 and interconnect 107.

This method is characterized by a high etching selectivity (SiO₂/Si₃N₄), with which the via hole 105 can be accurately formed while simultaneously forming the interconnective ditch 104 and via hole 105, through an etching process using a ditch-etching-stopper film 9 made of trisilicon tetranitride (Si₃N₄).

However, since it is extremely difficult to secure the etching selectivity in the shoulder area, the aperture area 202 of the via hole is formed, so as to be in a tapered shoulder-shape. Also, in the case where the aspect ratio of the via hole 105 is high, it is difficult to form an exact and neat via hole (105) by an etching process with high etching selectivity (SiO₂/Si₃N₄) . This gives a certain limit to the aspect ratio of the via hole 105.

Furthermore, in the case of using the ditch-etching-stopper film 9 made of a trisilicon tetranitride (Si₃N₄), since the dielectric constant of the Si₃N₄ film is larger than that of the SiO₂ film, the capacitance between interconnects is large. That is, the ditch-etching-stopper film 9 is a factor for impeding a possible improvement in the performance of the semiconductor device.

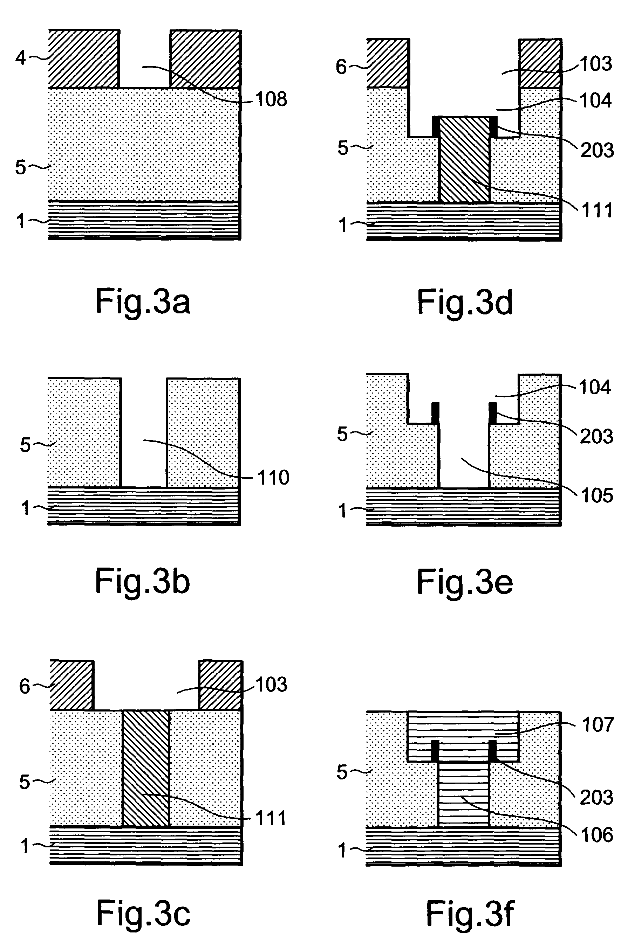

In order to solve this problem, another conventional type of dual damascene process, which consists of fabricating a semiconductor device as shown in Fig. 3, is proposed. This technique is disclosed in Japanese Patent Applications Laid-open Nos. Hei 8-335634 and Hei 10-223755.

First, as shown in Fig. 3a, an interlayer film 5 is formed on a conductor 1. The interlayer film 5 is then coated with an initial photosensitive organic film 4; which is then subjected to an exposure and a development process, so as to form a hole 108 on the initial photosensitive organic film 4.

Next, as shown in Fig. 3b, a via hole 110 reaching down to the surface of the conductor 1 is formed by selectively etching the interlayer film 5 using the initial photosensitive organic film 4 as a mask. The photosensitive organic film 4 is then removed.

Afterwards, as shown in Fig. 3c, the via hole 110 is filled with a protective film 111, made of an organic compound with its etch rate being less than half that of the interlayer film 5. The interlayer film 5 is then coated with a second photosensitive organic film 6; which is then subjected to an exposure and a development process, so as to form a ditch 103 on the second photosensitive organic film 6.

Thereafter, as shown in Fig. 3d, an interconnective ditch 104 is formed by an etching process, using the second photosensitive organic film 6 as a mask. Then, as shown in Fig. 3e, the second photosensitive organic film 6 and protective film 111 are removed to complete the interconnective ditch 104 and also to form a via hole 105.

Lastly, as shown in Fig. 3f, the via hole 105 and interconnective ditch 104 are filled with an interconnective material, which is then subjected to the CMP process; thus forming a via plug 106 and an interconnect 107.

In this method, since the etching process as described above does not need to be executed with a high etching selectivity (SiO₂/Si₃N₄), a tapered shoulder such as those (202) in Fig. 2e cannot happen. Also, the aspect ratio of the via hole cannot be limited, due to the etch selectivity (SiO₂/Si₃N₄).

Furthermore, since the ditch-etching-stopper film 9 is unnecessary, a trisilicon tetranitride film (i.e., a Si₃N₄ film) is also unnecessary. Therefore, any increase in the capacitance between the interconnects cannot be expected.

However, according to the conventional dual damascene process for the fabricating of a semiconductor device, as shown in Figs. 3a to 3f, using the protective film 111, made of an organic compound with its etching rate being less than half that of the interlayer film 5 allows a part of the protective film 111 to exist within the interconnective ditch 104. At this time, it is discovered that an etch residue 203 is formed on the side walls of the protective film 111 in the ditch 104, as shown in Fig. 3d. This etch residue 203 is expected to be either a thin oxide film or an etching byproduct. Therefore, this etch residue 203 can not be removed and remains in the ditch 104 when the protective film 111 is selectively removed, as shown in Fig. 3d. Since this etch residue 203 is mechanically brittle and easy to break, the interconnect electromigration endurance may deteriorate.

Also, according to the conventional process for fabricating a semiconductor device, as shown in Figs. 3a to 3f, a high ionic energy/plasma etching process needs to be executed for etching an oxide film, so that the hole (110) with a high aspect ratio can be precisely and neatly formed. This oxide film etching forms a damaged layer on the conductor; thus causing an increase in the via resistance.

Japanese Patent Applications Laid-Open Nos. Hei 10-261707, Hei 10-284600, Hei 10-27849 and Hei 10-233452 disclose methods dependent on the dual damascene process of forming multi-layered interconnects. However, as the protective film 111 in the Figs. 3a-3f, in the dual damascene process of forming an interconnect using a dummy plug, it does not technically explain how to improve the interconnect electromigration endurance.

### SUMMARY OF THE INVENTION

Accordingly, the objective of the present invention is to improve the weak points of the above-mentioned conventional techniques and to provide a semiconductor device along with its manufacturing method, which can improve the interconnect electromigration endurance; control a possible increase in the via resistance; and evade an interconnect fracture, when forming a multi-layered semiconductor device through the use of the dual damascene process.

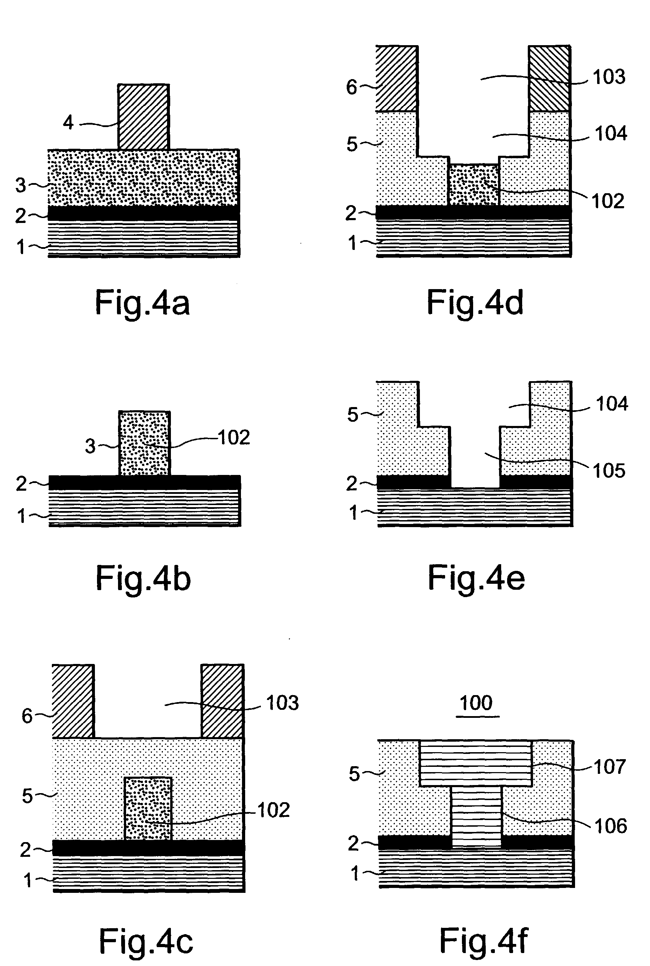

According to an aspect of the present invention, a method of manufacturing a semiconductor device is provided, and is comprised of fabricating a dummy plug (102, 302) and an interlayer insulating film (5, 15), with the interlayer insulating film (5, 15) being made of a material which is different from that of the dummy plug (102, 302), so as to cover, at least, the side wall of the dummy plug (102, 302) on a conductive film (1); forming a mask layer (6) on top of the interlayer insulating film (5, 15), where the mask layer has an aperture (103) with its width being longer than that of the dummy plug (102, 302); and forming an interconnective ditch (104) in the insulation film (5, 15) so as to expose the top surface of the dummy plug (102, 302) on the bottom of the interconnective ditch (104), by etching off part of the interlayer insulating film (5, 15) using the mask layer as an etching mask, wherein the top surface of the dummy plug (102, 302) is located at either an identical level to or a lower level than the bottom of the interconnective ditch (104). An example of the method of manufacturing the semiconductor device is illustrated in Figs. 4a to 4f.

Thus, according to the present invention, since the dummy plug does not exist in the interconnective ditch (104) when the interconnection ditch (104) is formed, a formation of etch residue is not caused. Therefore, the interconnect electromigration endurance is not deteriorated.

### BRIEF DESCRIPTION OF DRAWINGS

The above and other objects, features and advantages of the present invention will become more apparent from the following detailed descriptions, when taken in conjunction with the accompanying drawings, wherein:
Figs. 1a to 1f are cross sections showing the conventional method, dependent upon the single damascene process for manufacturing a semiconductor device.
Figs. 2a to 2f are cross sections showing the conventional method, according to the dual damascene process for manufacturing a semiconductor device.
Figs. 3a to 3f are cross sections showing the conventional method dependent upon a dual damascene process of manufacturing a semiconductor device.
Figs. 4a to 4f are cross sections cut along a line AA' in Fig. 5 showing a method of manufacturing a semiconductor device, according to the first embodiment of the present invention.
Fig. 5 illustrates an aerial view of the semiconductor device as shown in Figs. 4a to 4f, according to the present invention.
Figs. 6a to 6f are cross sections cut along a line AA' in Fig. 5 showing a method for manufacturing a semiconductor device, according to a second embodiment of the present invention.
Fig. 7 is a cross section showing a process of a method of manufacturing a semiconductor device, according to the first embodiment of the present invention.

### DETAILED DESCRIPTION OF THE PREFERRED EMBODIMENTS

Hereafter, several embodiments of the present invention will be described with reference to the drawings.

### (First embodiment)

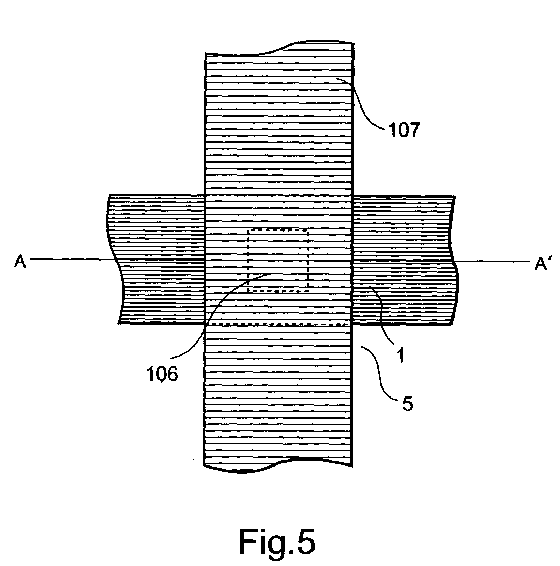

Next, a method of manufacturing a semiconductor device, according to a first embodiment of the present invention, will be described with reference to Figs. 4a to 4f and 5.

Figs. 4a to 4f illustrate cross sections cut along a line AA' in Fig. 5, showing process steps of fabricating the semiconductor device; whereas Fig. 5 illustrates an aerial view of part of a semiconductor device 100, according to the first embodiment of the present invention.

First, as shown in Fig. 4a, a stopper film 2 made of, for example, an oxide film is deposited on top of a conductive layer 1 (e.g., an interconnect). A dummy plug film 3 made of, for example, a SiON film is then deposited on top of the stopper film 2. Afterwards, the top surface of the dummy plug film 3 is coated with an initial photosensitive organic film 4; which is then subjected to an exposure and a development process, so as to form a plug mask.

Afterwards, as shown in Fig. 4b, the dummy plug film 3 is selectively etched off, deeply until it reaches the top surface of the stopper film 2, using the plug mask 101 so that a dummy plug 102 can be formed. Therefore, the top surface of the conductive layer 1 cannot be changed, due to this etching process. In order to be sure to stop the etching process, the etching end point needs to be detected during the etching process. Besides, a high etch selectivity material (SiON/siO₂) is used for etching. The detecting of the etching end point can be done by measuring a certain wave of light, which is emitted at the beginning of the stopper film 2.

After the dummy plug 102 has been formed, the plug mask 101 is removed using O₂ plasma. An interlayer film 5 made of, for example, a SiO₂ film is then deposited, covering the dummy plug 102. The top surface of the interlayer film 5 is then subjected to the CMP (chemical mechanical polishing) process; thus becoming smooth. Afterwards, as shown in Fig. 4c, the top surface of the interlayer film 5 is coated with a photosensitive organic film 6; which is then subjected to an exposure and a development process, so as to form an aperture 103.

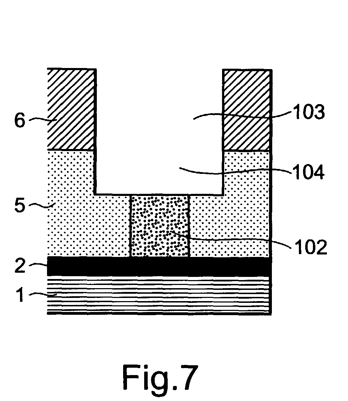

Thereafter, as shown in Fig. 4d, the interlayer film 5 is selectively etched off via the aperture 103, deeply, until it reaches the top surface of the dummy plug 102, in such a condition that the etching rate of the dummy plug 102 is larger than that of the interlayer film 5; thus forming an interconnective ditch 104. As a result, the dummy plug 102 no longer exists within the interconnective ditch 104 and etch residue cannot be generated in the interconnective ditch 104. Fig. 4d illustrates the case where the upper area of the dummy plug 102 is also etched off so that the top surface of dummy plug 102 is located below the bottom of the interconnective ditch 104. However, the present invention is not limited to this. Since it is only necessary that the dummy plug 102 should not project into the interconnective ditch 104 when forming the interconnective ditch 104, it is also allowable that the height of the bottom of the interconnective ditch 104 be equal to that of the top surface of the dummy plug 102, as shown in Fig.7.

The depth of the interconnective ditch 104 can be precisely controlled by detecting the time when the dummy plug 102 starts being etched, based upon the emitted light wave. After the interconnective ditch 104 has been formed, as shown in Fig. 4e, the photosensitive organic film 6 is removed using O₂ plasma. The dummy plug 102 and stopper film 2 are then removed. In the case where, for example, the interlayer film 5 and stopper film 2 are both made of a SiO₂ film and the dummy plug 102 is made of a SiON film; an isotropic plasma etching process, using a CFC gas (chlorofluorocarbon gas), a halogen gas, or a mixture of them, can selectively remove the dummy plug 102. Thus, the SiON film (i.e., the dummy plug) 102 is selectively etched off with practically nothing of the interlayer film 5 and stopper film 2 being etched.

On the other hand, the stopper film 2 can be selectively removed by a low ionic energy/plasma etching process, mainly using the CFC gas without damaging the conductive layer 1.

After the dummy plug 102 and the stopper film 2 right under it have been removed, as shown in Fig. 4f, the via hole 105 and interconnective ditch 104 are filled with an interconnective material (e.g. Cu); which is then subjected to the CMP process, so that the via plug 106 and interconnect 107 can be simultaneously formed.

It is noted that in the case where the stopper film 2 is made of an oxide film and the dummy plug is made of a SiON film, the isotropic plasma etching process and low ionic energy/plasma etching process can be consecutively executed by, for example: the remote etching system, which uses a gas of CF4, so as to selectively etch off the two films. Alternatively, the isotropic plasma etching process and low ionic energy/plasma etching process can be independently executed through the respective etching systems.

It is also noted that when the stopper film 2 is made of SiO₂, Si₃N₄, SiON, or similar material, the aforementioned stopper film 2 can be selectively etched off by the parallel plate reactive ion etching system in the following typical conditions, without damaging the conductive layer 1: Pressure = 5 pa; RF power = 500 W; and Rate of flow of CF4 = 60 sccm.

It is also noted that the wet etching process or low ionic energy/plasma etching process can be executed to selectively remove the stopper film 2 in place of the isotropic plasma etching process.

It is also noted that the dummy plug 2, the interlayer film 5, and the stopper film 2, as described above, can be alternatively made of a nitride film (Si₃N₄), a SiON film (SiₓO_{y}N_{Z}), an oxide film (SiO₂), a SiOF film (Si_{X}O_{y}F_{z}), a silicon film (Si), an inorganic oxide film, etc., or a preferred mixture of them. It is desirable that the dummy plug 2 is not made of an organic compound, due to the following reason: If the dummy plug is made of an organic compound, it would be difficult to selectively etch off the dummy plug with its etching rate being larger than that of the interlayer film and while also maintaining the etching selectivity of the photosensitive organic film, in the case where the dummy plug and photosensitive organic film have both been made of a similar organic compound.

### (Second embodiment)

According to the first embodiment, if the mask layer 6 is poorly aligned causing the aperture 103 to be displaced, then the contact area of the interconnect 107 with the via plug 106 is small. Accordingly, a method of manufacturing a semiconductor device, according to the second embodiment of the present invention, is provided solving this problem.

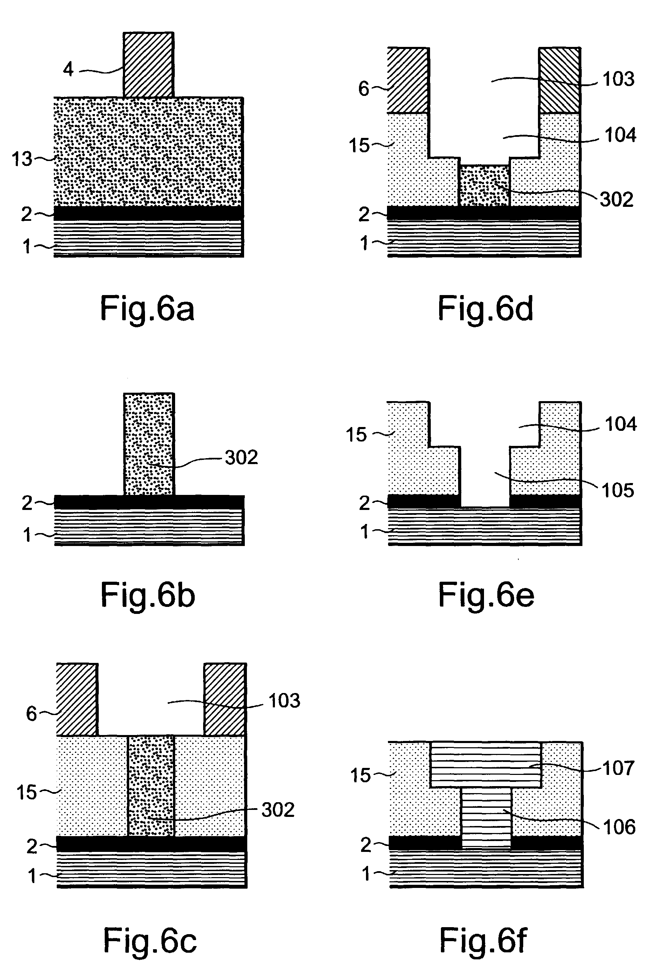

The second embodiment will be detailed, while referencing Figs. 6a to 6f. Figs. 6a to 6f are cross sections, cut along a line AA' in Fig. 5, showing the process steps for fabricating a semiconductor device.

First, as shown in Fig. 6a, a stopper film 2 made of, for example, an oxide film (e.g., SiO₂) is deposited on top of a conductive layer 1 (e.g., an interconnect or a diffused layer) . A dummy plug film 13 made of, for example, a SiON film with its thickness being equal to or longer than the sum of the expected depths of to-be-formed interconnective ditch 104 and to-be-formed via hole 105, is deposited next, on top of the stopper film 2. Afterwards, the top surface of the dummy plug film 13 is coated with a initial photosensitive organic film 4; which is then subjected to an exposure and a development process, so as to form a plug mask.

Afterwards, as shown in Fig. 6b, the dummy plug film 13 is selectively etched off deeply, to the top surface of the stopper film 2, using the plug mask 101, so as to form a dummy plug 302. Therefore, the top surface of the conductive layer 1 cannot be changed with the plasma etching process, since the conductive film 1 has not been directly exposed to plasma. In order to be sure to stop the etching process when it reaches the top surface of stopper film 2, the etching end point needs to be detected during the etching process. Besides, a high etch selectivity material (SiON/SiO₂) is used for etching. The detecting of the etching end point can be done by measuring a certain wave of light, which is emitted at the beginning of the stopper film 2, in the same manner as described in the first embodiment. After the dummy plug 302 has been formed, the plug mask 101 is removed using O₂ plasma.

Afterwards, an interlayer film 15 made of, for example, a SiO₂ film is deposited covering the dummy plug 302. The deposited interlayer film 15 is then subjected to the CMP (chemical mechanical polishing) process, so that its surface can become smooth with its height being equal to that of the dummy plug 302. As shown in Fig. 6c, the top surfaces of both the interlayer film 15 and dummy plug 302 are coated with a photosensitive organic film 6; which is then subjected to an exposure and a development process, so as to form an aperture 103.

Thereafter, as shown in Fig. 6d, the interlayer 15 and dummy plug 302 are selectively etched off via the aperture 103 to a certain depth of the interlayer 15 in conditions such that the etch rate of the dummy plug 302 is larger than that of the interlayer film 15. As a result, an interconnective ditch 104 is formed. Since the etching process completely removes the dummy plug 302 from the interconnective ditch 104, etching residue cannot be generated in the interconnective ditch 104.

After the interconnective ditch 104 has been formed, as shown in Fig. 6e, the photosensitive organic film 6 is removed using O₂ plasma. The dummy plug 302 and stopper film 2 are then removed. In the case where, for example, the interlayer film 5 and stopper film 2 are both made of a SiO₂ film, and the dummy plug 302 is made of a SiON film; an isotropic plasma etching process using a CFC gas (chlorofluorocarbon gas), a halogen gas, or a mixture of them can remove the dummy plug 302. Accordingly, the SiON film 302 is selectively etched off with practically nothing of the interlayer film 5 and stopper film 2 being etched. It is noted that the stopper film 2 can be selectively removed using a low ionic energy/plasma etching process; mainly using the CFC gas without damaging the conductive layer 1.

After the dummy plug 102 and the stopper film 2 right under it have been removed, as shown in Fig. 6f, the via hole 105 and interconnective ditch 104 are both filled with an interconnective material (e.g. Cu) and then subjected to the CMP process, so that via plug 106 and interconnect 107 can be simultaneously formed.

In summary, according to the second embodiment, since a thick dummy plug 302 is deposited, the processing of it may be more difficult than in the first embodiment (e.g., its vertical patterning may be more difficult). However, even if the mask layer 6 is poorly aligned, the interconnect 107 can be connected to the via plug 106 via the aperture area of the via plug 106 as long as at least part of the dummy plug 302 is exposed to the aperture 103 of the mask layer 6. This prevents a possible decrease in the contact area between the interconnect 107 and the via plug 106.

### [Results of the present invention]

According to the method of manufacturing the semiconductor device of the present invention, as described above, the dummy plug 2 is made of a nitride film (Si₃N₄), a SiON film (Si_{X}O_{y}N_{z}), an oxide film (SiO₂) , a SiOF film (SiₓO_{y}F_{z}), a silicon film (Si), an inorganic oxide film, etc, or a preferred mixture of them and the interconnective ditch is formed by the etching process executed in conditions such that the etch rate of the dummy plug is larger than that of the interlayer film. With this method, since no dummy plug is left within each of the interconnective ditches, no etching residue can be generated in it. As a result, the electromigration endurance of the interconnect in a semiconductor device can be improved.

Furthermore, in the aforementioned first and second embodiments, the stopper film 2 is deposited on top of the conductive layer I. However, this is not always necessary for the etching processes as described above. Even without the formation of the stopper film 2, the semiconductor device of the present invention can be fabricated and provide a similar result to those of the first and second embodiments.

Furthermore, according to the manufacturing method of the present invention, since the dummy plug and the stopper film right under it are both removed by a low ionic energy/plasma etching process, an isotropic plasma etching process, or a wet etching process; no damaged region can be formed in/on the via plug, which is on top of the conductive layer. As a result, a possible increase in the resistance of the via plug can be prevented from occurring, due to a damaged region.

Furthermore, instead of the fabrication process shown in Figs. 6a-6c, a fabrication process as shown in Figs.3a-3c, that is, a hole is formed in an interlayer insulating film 15 and a dummy plug 302 is embedded in the hole, can be used.

Several methods of manufacturing a semiconductor device, according to the present invention, have been described in connection with certain preferred embodiments. It is to be understood that the subject matter encompassed by the present invention is not limited to these specific embodiments. On the contrary, it is intended to include all alternatives, modifications, and equivalents as can be included within the spirit and scope of the following claims.

## Claims

1. A method of manufacturing a semiconductor device, comprising:
fabricating a dummy plug (102, 302) and an interlayer insulating film (5, 15) which is different from said dummy plug (102, 302) in material, so as to cover, at least, a side wall of said dummy plug (102, 302) on a conductive film (1);
forming a mask layer(6), which has an aperture (103) above said dummy plug (102, 302), on said interlayer insulating film (5, 15); and
forming an interconnective ditch (104) in said insulation film (5, 15) so as to expose a top surface of said dummy plug (102, 302) on a bottom of said interconnective ditch (104), by etching off a part of said interlayer insulating film (5, 15) using said mask layer as a mask, wherein said top surface of said dummy plug (102, 302) is located at either an identical level to or a lower level than said bottom of said interconnective ditch (104).

2. The method of manufacturing a semiconductor device, according to claim 1, wherein said forming said interconnective ditch is performed in a condition that an etching rate of said dummy plug (102, 302) is larger than that of said interlayer insulating film (5, 15).

3. The method of manufacturing a semiconductor device, according to claim 1, wherein said interlayer insulating film (5, 15) is formed to cover said dummy plug (102, 302) in said fabricating of said dummy plug (102) and said interlayer insulating film (5); and said interconnective ditch (104) is formed within a partial area of said interlayer insulating film (5, 15) covering over said top surface of said dummy plug (102, 302).

4. The method of manufacturing a semiconductor device, according to claim 1, wherein said fabricating of said dummy plug (102, 302) and said interlayer insulating film (5, 15) is performed so as for their respective heights to be almost equal to each other.

5. The method of manufacturing a semiconductor device, according to claim 1, wherein said dummy plug (102, 302) is fabricated through the following procedures: depositing a dummy plug film (3, 13) on top of said conductive film (1) and selectively etching off a part of said dummy plug film (3, 13).

6. The method of manufacturing a semiconductor device, according to claim 1, further comprising: forming a via hole (105) by removing said dummy plug (102, 302) and filling in both said interconnective ditch (104) and said via hole (105) with a conductive material so as to monolithically form a buried interconnect (107) and a via plug (106).

7. The method of manufacturing a semiconductor device, according to claim 1, wherein at least a part of said dummy plug (3) is etched so that at least a part of a via hole is formed beneath said bottom of said interconnective ditch (104) in said forming of said interconnective ditch (104).

8. The method of manufacturing a semiconductor device, according to claim 1, wherein said dummy plug (3, 13) is made of an inorganic material.

9. The method of manufacturing a semiconductor device, according to claim 8, wherein said inorganic material is made of, at least, a material of either: a nitride film (Si₃N₄), a SiON film (SiₓO_{y}N_{z}), an oxide film (SiO₂) , a SiOF film (SiₓO_{y}F_{z}), a silicon film (Si), an inorganic oxide film.

10. The method of manufacturing a semiconductor device, according to claim 5, further comprising depositing a stopper film (2) on said conductive film (1), which is performed before said dummy plug (3, 302) and said interlayer insulating film (5, 15) are formed; wherein said stopper film (2) plays the role in stopping the progress of said etching.

11. The method of manufacturing a semiconductor device, according to claim 10, further comprising removing said dummy plug (3, 302) so as to expose a part of said stopper film (2), and selectively removing said part of said stopper film (2) so as to form a via hole (106).

12. The method of manufacturing a semiconductor device, according to claim 6, wherein said removing of said dummy plug (102, 302) is performed by an isotropic plasma etching process using either: a CFC gas, a halogen gas, or any preferred mixture of them.

13. The method of manufacturing a semiconductor device, according to claim 11, wherein said selective removal of said part of said stopper film (2) is performed by a low ionic energy/plasma etching process using the CFC gas.
